# EUROPÄISCHE PATENTANMELDUNG

(11) **EP 1 564 888 A2**
(43) Veröffentlichungstag der Anmeldung: **17.08.2005**
(21) Anmeldenummer: 05100272.3
(22) Anmeldetag: 18.01.2005
(51) Int. Cl.: H03K 17/95

(54) **Näherungsschalter**

(30) Priorität: 12.02.2004 DE 102004006901
(71) Anmelder: Werner Turck GmbH & Co. KG, D-58553 Halver (DE)
(72) Erfinder: Wendler, Torsten, 08340 Schwarzenberg (DE)
(74) Vertreter: Rieder, Hans-Joachim, Dr.

(57) **Zusammenfassung**

Die Erfindung betrifft einen Näherungsschalter zur Erzeugung eines Ausgangsschaltsignales (A), welches wechselt, wenn ein Auslöser einen vorgegebenen Auslöseabstand erreicht, mit einer einen Oszillator (10) aufweisenden Sensoranordnung (2), wobei der Oszillator (10) von einer Oszillatorspannungsversorgung (3) spannungsversorgt wird, mit einem Schwellwertschalter (14), an welchem ein vom Abstand des Auslösers abhängiges Sensorsignal (6) und eine Schwellspannung (9) anliegen, und mit einer einen Temperaturfühler (7) aufweisenden Temperatur-Kompensierungseinrichtung, welche unter Verwendung von der jeweiligen vom Temperaturfühler (7) gemessenen Temperatur zugeordneten Kompensationswerte den Auslöseabstand temperaturstabilisiert. Wesentlich ist, dass bei einer auf einem festen Wert gehaltenen Schwellspannung (9) die Temperatur-Kompensierungseinrichtung die Oszillatorspannungsversorgung (3) beeinflusst. Bevorzugt ist, dass das Sensorsignal (6) von einer Differenzspulenanordnung (L2, L3) aufweisenden Sensoranordnung (2) erzeugt wird.

## Beschreibung

Die Erfindung betrifft einen Näherungsschalter zur Erzeugung eines Ausgangsschaltsignales, welches wechselt, wenn ein Auslöser einen vorgegebenen Auslöseabstand erreicht, mit einer einen Oszillator aufweisenden Sensoranordnung, wobei der Oszillator von einer Oszillatorspannungsversorgung spannungsversorgt wird, mit einem Schwellwertschalter, an welchem ein vom Abstand des Auslösers abhängiges Sensorsignal und eine Schwellspannung anliegen, und mit einer einen Temperaturfühler aufweisenden Temperatur-Kompensierungseinrichtung, welche unter Verwendung von der jeweiligen vom Temperaturfühler gemessenen Temperatur zugeordneten Kompensationswerte den Auslöseabstand temperaturstabilisiert.

Ein Näherungsschalter dieser Art ist aus der DE 195 27 174 C2 vorbekannt. Bei diesem berührungslos arbeitenden Näherungsschalter besitzt die Sensoranordnung einen aus einer Spule und einem Kondensator bestehenden Oszillator, der von einer Oszillatorspannungsversorgung spannungsversorgt wird. Dieser Näherungsschalter wird bei unterschiedlichen Temperaturen verwendet. Um zu gewährleisten, dass der Näherungsschalter einen temperaturunabhängigen Schaltabstand besitzt, bei welchem das Ausgangssignal umschaltet, also beispielsweise seinen Zustand von low auf high wechselt, ist dort eine Temperaturkompensierungseinrichtung vorgesehen, die einen Temperaturfühler aufweist, der in unmittelbarer Nähe des Oszillators angeordnet ist. Das von der Sensoranordnung gelieferte Sensorsignal, welches an einem Schwellwertschalter anliegt, ist temperatur-variabel. Die Kompensation erfolgt hier durch eine entsprechende Erhöhung bzw. Verringerung der Schwellspannung. Die entsprechenden Werte für die Schwellspannung sind in einem Digitalwertspeicher abgelegt.

Aus der DE 4123 828 C1 ist ein Verfahren bekannt, mit welchem ein eine Prrogrammiereinheit aufweisender Näherungsschalter programmierbar ist.

Die DE 39 31892 beschreibt einen Näherungsschalter, der einen LC-Kreis aufweist. Der dem LC-Kreis aufgeprägte Strom kann abhängig von der Umgebungstemperatur gesteuert werden.

Die DE 39 16 386 beschreibt einen induktiven Näherungsschalter mit einem LC-Kreis, in welchem ein Schwingkreistransistor geschaltet ist. Der Schwingkreis wird mit einem Grundstrom bestromt. Von einer zweiten, einstellbaren Stro m-quelle wird in den Emitterkollektorkreis des Schwingkreistransistors ein Kompensationsstrom eingespeist, dessen Größe von einer Steuereinrichtung bestimmt wird, die einen Sensor für die Temperatur des Schwingkreistransistors aufweist.

Ein Verfahren, um einen Einstellwert in einen programmierbaren Näherungsschalter einzustellen, beschreibt die DE 40 06 893 C2.

Die DE 100 54 288 A1 beschreibt eine Sensoranordnung zur Verfassung eines Meßwertes, mit welcher Parameterwerte an eine Sensoranordnung übertragbar sind.

Ein Näherungsschalter mit einer Differenzspulenanordnung ist aus der DE 40 31252 C1 vorbekannt. Bei diesem Näherungsschalter erzeugt ein aus einem Kondensator und einer Spule bestehender Oszillator ein Wechselfeld mit einer Frequenz von ca. einem Megahertz. Dieses Wechselfeld erregt in einem metallischen Auslöser ein Wirbelfeld. Dieses induziert in einer Differenzspulenanordnung eine Differenzspannung, die zur Mitkopplung des Oszillators bzw. zum Erzeugen eines Ausgangssignales verwendet wird.

Ausgehend von dem eingangs genannten Stand der Technik liegt der Erfindung die Aufgabe zugrunde, die Temperaturkompensation an Näherungsschaltern gebrauchsvorteilhaft weiterzubilden.

Gelöst wird die Aufgabe durch die in den Ansprüchen angegebene Erfindung.

Der Anspruch 1 sieht zunächst und im Wesentlichen vor, dass die Schwellspannung auf einem festen Wert gehalten wird. Die Kompensation erfolgt unmittelbar im Bereich der Sensoranordnung derart, dass die Temperatur-Kompensierungseinrichtung die Oszillatorspannungsversorgung beeinflusst. Es hat sich insbesondere bei Näherungsschaltern, die nach dem Differenzspulenprinzip arbeiten, gezeigt, dass über die Veränderbarkeit der Oszillatorspannung Einfluss auf die Verstärkung und damit auf den Schaltabstand genommen werden kann. Diese Änderung der Oszillatorversorgungsspannung erfolgt vorzugsweise über einen einstellbaren Spannungsregler. Dieser wird von einem Microcontroller angesteuert. In einer bevorzugten Weiterbildung der Erfindung liefert der Microcontroller an einem seiner Ausgänge ein pulsweitenmoduliertes Steuersignal für einen Spannungsregler. Das pulsweitenmodulierte Signal besteht aus zeitlich regelmäßig nacheinander folgenden Pulsen mit gleicher Amplitude. Bei diesen Pulsen kann es sich um Rechteckpulse oder um anders geformte Pulse handeln. Die Spannung wird durch eine Variation der zeitlichen Dauer, also der Pulsweite variiert. Das pulsweitenmodulierte Steuersignal wird vorzugsweise von einem Tiefpassfilter geglättet. Die Spannung des geglätteten Signales ist dabei im Wesentlichen zur Fläche der Steuerimpulse proportional. Über einen Impendanzwandler kann dieses Gleich-Spannungs-Steuersignal auf die Basis eines Transistors gebracht werden. Es ist ferner vorgesehen, dass der Temperaturfühler von ein oder mehreren in Serie geschalteten Dioden gebildet wird. Die Flussspannung dieser Diodenanordnung ist temperaturabhängig und wird von einem Analog/ Digitalwandler des Microcontrollers gemessen. Anhand dieses Meßergebnisses wird aus einem nichtflüchtigen Speicher, beispielsweise einem EEPROM ein Kompensationswert ausgelesen. Dieser Kompensationswert bestimmt die Pulsweite des Steuersignals für die Oszillatorspannungsversorgung. Der Ausgang des Microcontrollers erhält sein Signal vom Schwellwertschalter und wechselt seinen Zustand von low nach high oder umgekehrt, wenn der Auslöser den Auslöseabstand erreicht. Die Sensoranordnung entspricht vorzugsweise derjenigen, die die DE 40 31252 C1 beschreibt. Bei nicht angenähertem Auslöser befindet sich der Oszillator der Sensoranordnung vorzugsweise in einem nicht schwingenden Zustand. Der Oszillator der Sensoranordnung schwingt erst dann an, wenn der Auslöser den Auslöseabstand erreicht. Die Differenzspannung zwischen den beiden Sensorspulen der Sensoranordnung wechselt dann das Vorzeichen, so dass eine Mitkopplung mit der Oszillatorspule gegeben ist.

Ein Ausführungsbeispiel der Erfindung wird nachfolgend anhand beigefügter Zeichnung erläutert. Es zeigen:

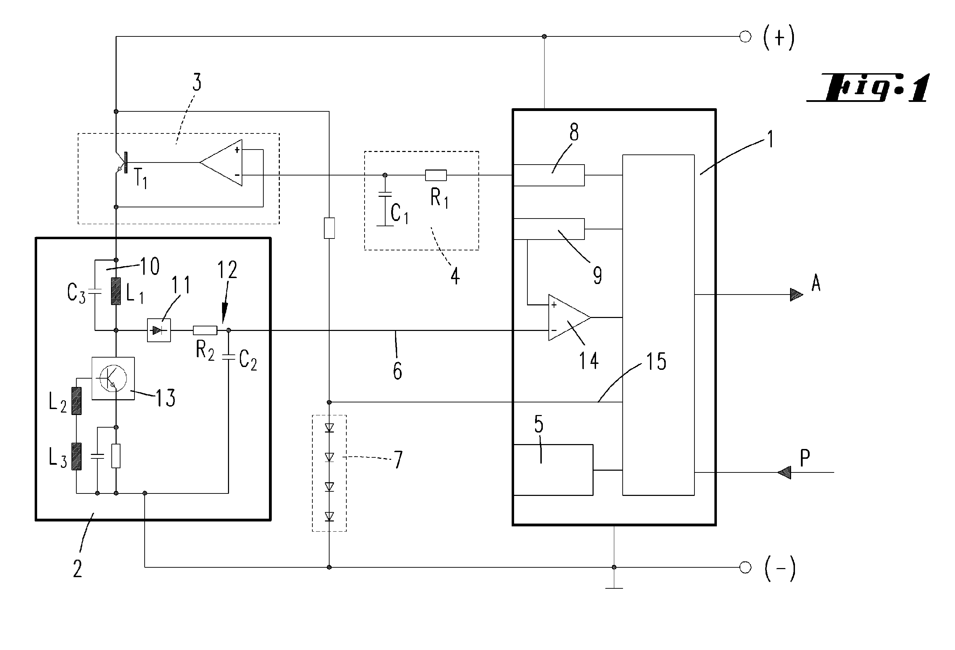

- Fig. 1: schematische Darstellung der wesentlichen Elemente der Schaltung eines erfindungsgemäßen Näherungsschalters.

Der Näherungsschalter besitzt einen Microcontroller 1 und einen insbesondere diskret aufgebauten Sensor 2. Die Ausgestaltung des Sensors entspricht im Wesentlichen demjenigen, der von der DE 40 31252 C1 beschrieben wird. Die Sensoranordnung 2 besitzt einen Oszillator 10, der von einem Kondensator C3 und einer parallel zu diesem geschalteten Spule L1 gebildet ist. Typischerweise liegt die Oszillatorfrequenz bei einem Megahertz. Der Oszillator wird von einer Sensorspulenanordnung L2, L3 über die Transistoranordnung 13 mitgekoppelt getrieben. Die Spulen L2, L3 sind entgegengerichtet in Reihe geschaltet und liegen hintereinander. Bei angenähertem Auslöser wird die an der Basis des Oszillatorverstärkers 13 anliegende Spannung bei Erreichen des Auslöseabstandes phasenrichtig zur Oszillatorspannung, so dass der Oszillator anschwingen kann.

Ein am Oszillatorverstärker 13 abgegriffenes Signal wird mittels des Gleichrichters 11 gleichgerichtet und mittels des Tiefpassfilters 12, welcher von dem Widerstand R2 und dem Kondensator C2 gebildet wird, geglättet.

Dieses Sensorsignal 6 wird an einen Schwellwertschalter 14 gegeben. Am Schwellwertschalter 14 liegt eine konstante Schwellspannung 9 an. Je nachdem, ob das Sensorsignal 6 über der Schwellspannung 9 oder unter der Schwellspannung 9 liegt, sind der Ausgang des Schwellwertschalters 14 und das Ausgangssignal A entweder high oder low.

Ein im Ausführungsbeispiel von vier in Serie geschalteten Dioden ausgebildeter Temperaturfühler 7 ist örtlich in der Nähe des Sensors 2 angeordnet und erzeugt ein von der Flussspannung der Dioden gebildetes Temperatursignal, welches von einem Analog/ Digital-Wandler des Microcontrollers 1 in einen Digitalwert (bzw. eine Adresse) gewandelt wird. Ein zu diesem Wert zugehöriger Kompensationswert wird sodann einem nichtflüchtigen Speicher 5, beispielsweise einem EEPROM entnommen. Der Microcontroller 1 erzeugt aus diesem Kompensationswert ein bestimmtes pulsweitenmoduliertes Steuersignal für eine Oszillatorspannungsversorgung 3. Schematisch ist ein derartiges pulsweitenmoduliertes Signal in der Figur 2 dargestellt. Im Ausführungsbeispiel handelt es sich dabei um in regelmäßigen Abständen einander zeitlich folgende Rechteckpulse. Die Pulsweite PW, also die zeitliche Dauer der Pulse kann variiert werden.

Dieses pulsweitenmodulierte Signal 8 wird einem aus einem Widerstand R1 und einem Kondensator C1 bestehenden Tiefpassfilter 4 zugeleitet. Das Ausgangssignal dieses Tiefpassfilters 4 ist ein Gleichspannungssignal, dessen Spannung proportional zur Pulsfläche des pulsweitenmodulierten Signales ist. Dieses Gleichspannungssignal wird auf einen als Impendanzwandler bzw. als Inverter geschalteten Operationsverstärker der Oszillatorspannungsversorgung 3 gegeben. Das Ausgangssignal des Operationsverstärkers liegt an der Basis eines Transistors T1 an, welcher die Versorgungsspannung des Oszillators 10 liefert.

Die Programmierung des Speichers 5 mit den Kompensationswerten erfolgt in bekannter Weise dadurch, dass der Näherungsschalter zunächst vormontiert wird. Er besitzt in diesem vormontierten Zustand einen Standardschaltabstand, der unter dem später zu kalibrierenden Auslöseabstand liegt. Zur Kalibrierung wird ein Auslöser mit dem Auslöseabstand vor der Sensorfläche des Sensors positioniert. Die Kalibrierung erfolgt bevorzugt in einem Temperaturschrank, wobei eine Temperaturrampe mit einem definierten Temperaturgradienten durchlaufen wird. Die Temperaturrampe kann beispielsweise in einem Bereich von -20°C bis +70°C durchfahren werden. In festgelegten Temperaturabständen, welche der Mikrocontroller 1 über die vier in Serie geschalteten Dioden erfasst, erfolgt der Abgleich. Dies geschieht dadurch, dass der Mikrocontroller 1 durch Änderung der Pulsweitenmodulation schrittweise die Oszillatorspannung variiert, insbesondere erhöht, bis der Oszillator anschwingt und das Ausgangssignal A des Schwellwertschalters 14 in der gewünschten Weise schaltet. Die zu dieser Oszillatorspannung korrespondierende Pulsweite wird dann im Speicher 5 abgespeichert. Die Aktivierung dieses Vorgangs erfolgt vorzugsweise über eine definierte Anhebung der Betriebsspannung.

Es wird nicht nur als besonderer Vorteil angesehen, dass zur Temperaturkompensation eine elektrisch einfach zu handhabende Größe, nämlich die von der Oszillatorspannungsversorgung 3 abgegebene Spannung variiert wird. Als besonderer Vorteil wird auch die hier verwendete Methode zur Erzeugung der Spannung angesehen. Diese wird aus einem pulsweitenmodulierten Signal gewonnen, welches von dem Microcontroller 1 abgegeben wird. Unter Zwischenschaltung des Tiefpassfilters 4 wird aus diesem Signal die Versorgungsspannung gewonnen. Hierdurch ist ein einfacher Aufbau gegeben.

Es wird als Vorteil angesehen, dass der Abgleich im Fertigungsprozess nach der gesamten Montage und nach dem Vergiessen aller Vergussteile erfolgt.

Alle offenbarten Merkmale sind (für sich) erfindungswesentlich. In die Offenbarung der Anmeldung wird hiermit auch der Offenbarungsinhalt der zugehörigen/ beigefügten Prioritätsunterlagen (Abschrift der Voranmeldung) sowie die zitierten Druckschriften vollinhaltlich mit einbezogen, auch zu dem Zweck, Merkmale dieser Unterlagen in Ansprüche vorliegender Anmeldung mit aufzunehmen.

## Patentansprüche

1. Näherungsschalter zur Erzeugung eines Ausgangsschaltsignales (A), welches wechselt, wenn ein Auslöser einen vorgegebenen Auslöseabstand erreicht, mit einer einen Oszillator (10) aufweisenden Sensoranordnung (2), wobei der Oszillator (10) von einer Oszillatorspannungsversorgung (3) spannungsversorgt wird, mit einem Schwellwertschalter (14), an welchem ein vom Abstand des Auslösers abhängiges Sensorsignal (6) und eine Schwellspannung (9) anliegen, und mit einer einen Temperaturfühler (7) aufweisenden Temperatur-Kompensierungseinrichtung, welche unter Verwendung von der jeweiligen vom Temperaturfühler (7) gemessenen Temperatur zugeordneten Kompensationswerte den Auslöseabstand temperaturstabilisiert, **dadurch gekennzeichnet, dass** bei einer auf einem festen Wert gehaltenen Schwellspannung (9) die Temperatur-Kompensierungseinrichtung die Oszillatorspannungsversorgung (3) beeinflusst.

2. Näherungsschalter nach Anspruch 1 oder insbesondere danach, **dadurch gekennzeichnet, dass** das Sensorsignal (6) von einer Differenzspulenanordnung (L2, L3) aufweisenden Sensoranordnung (2) erzeugt wird.

3. Näherungsschalter nach einem oder mehreren der vorhergehenden Ansprüche oder insbesondere danach, **dadurch gekennzeichnet, dass** die Oszillatorspannungsversorgung (3) ein im Wege einer Pulsweitenmodulation von einem Microcontroller (1) gesteuerter Spannungsregler ist.

4. Näherungsschalter nach einem oder mehreren der vorhergehenden Ansprüche oder insbesondere danach, **dadurch gekennzeichnet, dass** die pulsweitenmodulierten Steuerpulse von einem Tiefpassfilter (4) zu einer Steuerspannung geglättet werden.

5. Näherungsschalter nach einem oder mehreren der vorhergehenden Ansprüche oder insbesondere danach, **dadurch gekennzeichnet, dass** der Temperaturfühler (7) von ein oder mehreren Dioden gebildet ist.

6. Näherungsschalter nach einem oder mehreren der vorhergehenden Ansprüche oder insbesondere danach, **dadurch gekennzeichnet, dass** die Kompensationswerte als Digitalwerte in einem nichtflüchtigen Speicher (5) im Microcontroller (1) gespeichert werden.

7. Näherungsschalter nach einem oder mehreren der vorhergehenden Ansprüche oder insbesondere danach, **dadurch gekennzeichnet, dass** der Oszillator (10) bei entferntem Auslöser nicht schwingt und zu schwingen beginnt, wenn der Auslöser den Auslöseabstand erreicht.

8. Verfahren zum Kalibrieren der Temperaturkompensationseinrichtung eines Näherungsschalters, wobei bei verschiedenen Temperaturen mit einem sich im Auslöseabstand befindlichen Auslöser Korrekturwerte so lange geändert werden, bis das Ausgangssignal wechselt und der zugeordnete Korrekturwert in einem Speicher (5) abgespeichert wird, **dadurch gekennzeichnet, dass** während der Kalibrierung die Umgebungstemperatur stetig entlang einer Temperaturrampe geändert wird und in festgelegten Temperaturabständen der Abgleichvorgang ausgelö st wird.

9. Verfahren nach Anspruch 9 oder insbesondere danach, **dadurch gekennzeichnet, dass** während des Abgleichvorgangs der Microcontroller über eine Pulsweitenmodulation die Oszillatorspannung beginnend bei einem unteren Wert so lange ändert, bis der im nicht ausgelösten Zustand nicht schwingende Oszillator anschwingt.
